(19) Europäisches Patentamt / European Patent Office / Office européen des brevets

(11) **EP 4 290 491 A1**

(12) **EUROPEAN PATENT APPLICATION**
published in accordance with Art. 153(4) EPC

(43) Date of publication:
**13.12.2023 Bulletin 2023/50**

(21) Application number: **21930130.6**

(22) Date of filing: **10.03.2021**

(51) International Patent Classification (IPC):
**G08G 1/00** *(2006.01)*

(52) Cooperative Patent Classification (CPC):
**G08G 1/00**

(86) International application number:
**PCT/JP2021/009583**

(87) International publication number:
**WO 2022/190274 (15.09.2022 Gazette 2022/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **NEC Corporation
108-8001 Tokyo (JP)**

(72) Inventor: **NISHIDA, Masataka
Tokyo 108-8001 (JP)**

(74) Representative: **Vossius & Partner
Patentanwälte Rechtsanwälte mbB
Siebertstraße 3
81675 München (DE)**

(54) **SIMULATED ROAD GENERATION SYSTEM, SIMULATED ROAD GENERATION METHOD, AND NON-TRANSITORY COMPUTER-READABLE MEDIUM HAVING STORED THEREON PROGRAM FOR CAUSING COMPUTER TO PERFORM SIMULATED ROAD GENERATION PROCESS**

(57) A simulated road generation system (10) includes an acquisition unit (11), a detection unit (12), an estimation unit (13), and a generation unit (14). The acquisition unit (11) acquires an image indicating a surrounding of a vehicle, and position information of the vehicle. The detection unit (12) detects a demarcation line of a road from the image. The estimation unit (13) estimates, based on the position information of the vehicle and the demarcation line in the image, a road parameter including at least one of a number of lanes included in a predetermined region on a real space, a length of the lane, a width of the lane, and a curve curvature. The generation unit (14) generates a simulated road, based on the road parameter.

Fig. 1

**Description**

**Technical Field**

The present disclosure relates to a simulated road generation system, a simulated road generation method, and a non-transitory computer-readable medium, and more particularly, to a simulated road generation system, a simulated road generation method, and a non-transitory computer-readable medium that reproduce a road.

**Background Art**

In recent years, virtually reproducing a road has been performed in various scenes. For example, in order to study a movement of a vehicle on a road, reproducing a road on a simulator has been performed. In addition, for example, detecting a risk factor has been performed by comparing a captured image acquired by capturing a surrounding of a vehicle on a real space with a road virtually reproduced by a simulator.

Herein, a method of virtually reproducing a road, based on map information, has been proposed. For example, Patent Literature 1 describes a method of generating a map information image when visually recognized from the same direction as a captured image of an in-vehicle camera by using three-dimensional map information representing a contour line of a road. Note that, as a method of generating three-dimensional map information, for example, Patent Literature 2 discloses a three-dimensional map generation system that generates three-dimensional map information, based on measurement data of a measurement vehicle. In the three-dimensional map generation system, it is disclosed that three-dimensional map information based on measurement data of a measurement vehicle is interpolated based on measurement data of another measurement vehicle traveling in a vicinity of a defective area.

**Citation List**

**Patent Literature**

[Patent Literature 1] Japanese Unexamined Patent Application Publication No. 2019-164611
[Patent Literature 2] International Patent Publication No. WO2019/107367.

**Summary of invention**

**Technical Problem**

However, when a road is reproduced by the method described in Patent Literature 1 described above, labor and a cost that acquire three-dimensional map information first, calculate a road parameter necessary for reproducing a road from the three-dimensional map information or extract three-dimensional point cloud data, and input them to a simulator, are required. In addition, in a case of acquiring three-dimensional map information by the method described in Patent Literature 2 described above, in order to generate the three-dimensional map information by measurement, it is necessary to install an expensive laser scanner camera in a plurality of vehicles and then capture an image while traveling, thus more labor and a more cost are required. Therefore, in order to virtually reproduce a road, there is a problem that labor and a cost are required.

In view of the problem described above, an object of the present disclosure is to provide a simulated road generation system, a simulated road generation method, and a non-transitory computer-readable medium that can easily reproduce a road.

**Solution to Problem**

A simulated road generation system according to one aspect of the present disclosure includes:

an acquisition means for acquiring an image indicating a surrounding of a vehicle, and position information of the vehicle;
a detection means for detecting a demarcation line of a road from the image;
an estimation means for estimating, based on the position information of the vehicle and the demarcation line in the image, a road parameter including at least one of a number of lanes included in a predetermined region on a real space, a length of a lane, a width of a lane, and a curve curvature; and

a generation means for generating a simulated road, based on the road parameter.

A simulated road generation method according to one aspect of the present disclosure includes:

an acquisition step of acquiring an image indicating a surrounding of a vehicle, and position information of the vehicle;
a detection step of detecting a demarcation line of a road from the image;
an estimation step of estimating, based on the position information of the vehicle and the demarcation line in the image, a road parameter including at least one of a number of lanes included in a predetermined region on a real space, a length of a lane, a width of a lane, and a curve curvature; and
a generation step of generating a simulated road, based on the road parameter.

A non-transitory computer-readable medium according to one aspect of the present disclosure stores a program. The program causes a computer to execute

acquisition processing of acquiring an image indicating a surrounding of a vehicle, and position information of the vehicle,
detection processing of detecting a demarcation line of a road from the image,
estimation processing of estimating, based on the position information of the vehicle and the demarcation line in the image, a road parameter including at least one of a number of lanes included in a predetermined region on a real space, a length of a lane, a width of a lane, and a curve curvature, and
generation processing of generating a simulated road, based on the road parameter.

**Advantageous Effects of Invention**

The present disclosure can provide a simulated road generation system, a simulated road generation method, and a non-transitory computer-readable medium that can easily reproduce a road.

**Brief Description of Drawings**

Fig. 1 is a block diagram illustrating a configuration of a simulated road generation system according to a first example embodiment;
Fig. 2 is a flowchart illustrating a flow of a simulated road generation method according to the first example embodiment;
Fig. 3 is a block diagram illustrating a configuration of a system to which a simulated road generation apparatus can be applied;
Fig. 4 is a diagram for describing a simulated road generation method according to a second example embodiment;
Fig. 5 is a diagram for describing the simulated road generation method according to the second example embodiment;
Fig. 6 is a diagram for describing the simulated road generation method according to the second example embodiment;
Fig. 7 is a diagram for describing the simulated road generation method according to the second example embodiment;
Fig. 8 is a diagram for describing the simulated road generation method according to the second example embodiment;
Fig. 9 is a diagram for describing the simulated road generation method according to the second example embodiment;
Fig. 10 is a flowchart illustrating one example of a flow of the simulated road generation method according to the second example embodiment;
Fig. 11 is a diagram illustrating one example of a surrounding image according to the second example embodiment;
Fig. 12 is a block diagram illustrating a configuration of a system according to a third example embodiment;
Fig. 13 is a diagram for describing a simulated road generation method according to the third example embodiment;
Fig. 14 is a diagram for describing the simulated road generation method according to the third example embodiment;
Fig. 15 is a diagram for describing the simulated road generation method according to the third example embodiment;
Fig. 16 is a flowchart illustrating one example of a flow of the simulated road generation method according to the third example embodiment;
Fig. 17 is a block diagram illustrating a configuration of a system according to a fourth example embodiment;

Fig. 18 is a flowchart illustrating one example of a flow of a decision method according to the fourth example embodiment; and

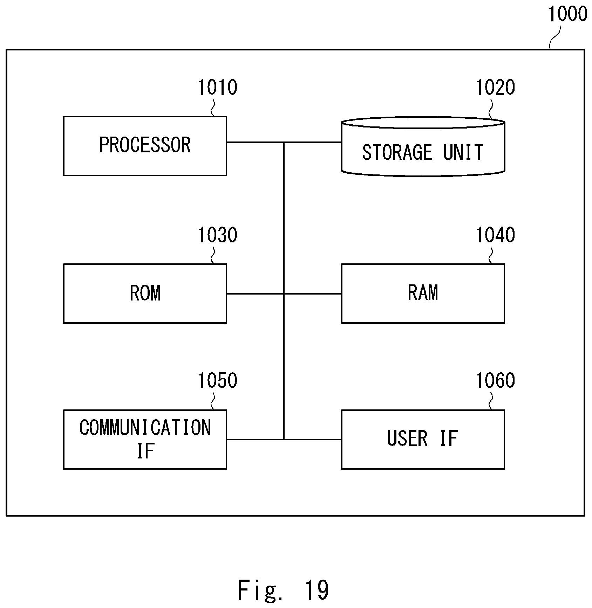

Fig. 19 is a diagram illustrating a configuration example of a computer that can be used as a simulated road generation apparatus and a vehicle apparatus.

**Example Embodiment**

Hereinafter, the present disclosure will be described through example embodiments, but the disclosure according to the claims is not limited to the following example embodiments. In addition, all of the configurations described in the example embodiments may not be essential as means for solving the problem. In each of the drawings, the same elements are denoted by the same reference signs, and redundant descriptions are omitted as necessary.

<First Example Embodiment>

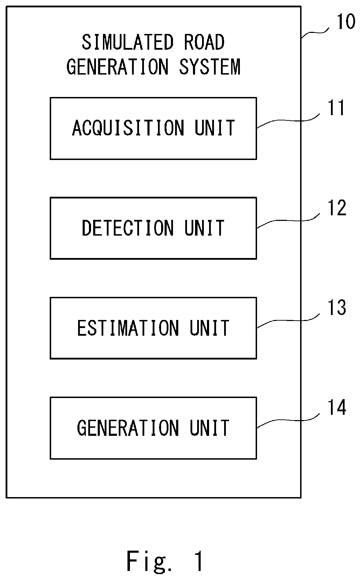

First, a first example embodiment of the present disclosure will be described. Fig. 1 is a block diagram illustrating a configuration of a simulated road generation system 10 according to the first example embodiment.

The simulated road generation system 10 is a computer system generating a simulated road on a simulator. The simulated road is a road which virtually reproduces a road on a real space. The simulator is an apparatus including a function of virtually reproducing a road, and is achieved by software or hardware, or a combination thereof. The simulated road generation system 10 includes an acquisition unit 11, a detection unit 12, an estimation unit 13, and a generation unit 14.

The acquisition unit 11 is also referred to as an acquisition means, and acquires a surrounding image indicating a surrounding of a vehicle, and position information of the vehicle. The surrounding image is a two-dimensional image, and includes an image region being acquired by capturing a surrounding of the vehicle, at least a demarcation line of a road. The surrounding image may be a captured image acquired by capturing a scene of a surrounding of the vehicle by an in-vehicle camera (not illustrated), or may be an image acquired by superimposing a predetermined image such as a guide line on the captured image. The acquisition unit 11 supplies the acquired surrounding image to the detection unit 12, and supplies the acquired position information of the vehicle to the estimation unit 13.

The detection unit 12 is also referred to as a detection means, and detects a demarcation line of a road from a surrounding image. The demarcation line is a line formed in white, yellow, or the like on a road surface. The demarcation line includes a center line, a lane boundary line, and a side strip. The detection unit 12 supplies information of the demarcation line to the estimation unit 13.

The estimation unit 13 is also referred to as an estimation means, and estimates a road parameter, based on position information of a vehicle and a demarcation line in a surrounding image. The road parameter includes an individual road parameter in a predetermined region. The individual road parameter indicates at least one of a number of lanes, a length of a lanes, a width of a lanes, and a curve curvature, and is estimated based on at least a demarcation line. For example, the road parameter may be information in which the individual road parameter is associated with position information of the predetermined region. The position information of the predetermined region is estimated based on at least position information of a vehicle. Note that, "a length of a lane" is a length of the lane in the predetermined region along a traveling direction of the vehicle, and "a width of a lane" is a length of the lane in the predetermined region along a direction orthogonal to the traveling direction of the vehicle. The estimation unit 13 supplies the road parameter to the generation unit 14.

The generation unit 14 is also referred to as a generation means, and generates a simulated road on a simulator, based on a road parameter. The simulated road may be model data indicating a three-dimensional shape of a road. In addition, the simulated road may be model data indicating a two-dimensional shape of a road in a case where the road is looked down from a predetermined point. Note that, the model data may be computer-aided design (CAD) data. In addition, the simulated road may indicate an image generated based on the model data.

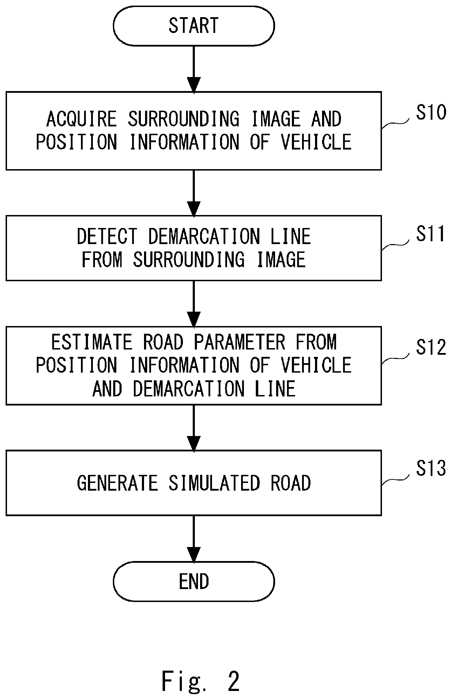

Fig. 2 is a flowchart illustrating a flow of a simulated road generation method according to the first example embodiment. First, the acquisition unit 11 of the simulated road generation system 10 acquires a surrounding image indicating a surrounding of a vehicle, and position information of the vehicle (step S 10). Next, the detection unit 12 detects a demarcation line of a road from the surrounding image (step S 11). Next, the estimation unit 13 estimates a road parameter, based on the position information of the vehicle and the demarcation line (step S12). Next, the generation unit 14 generates a simulated road on a simulator, based on the road parameter (step S13).

As described above, the simulated road generation system 10 according to the first example embodiment automatically generates a road parameter necessary for road reproduction, based on a surrounding image of a vehicle and position information of the vehicle, and sets the generated road parameter as an input of the simulator. Therefore, the simulated road generation system 10 can easily reproduce a road without requiring work of acquiring map information, calculating and inputting a parameter. When a wide region road is reproduced, an amount of map information to be acquired and an amount of parameters to be calculated and input become enormous, but the simulated road generation system 10 can more remarkably acquire an effect of reducing labor and a cost.

Note that, since the surrounding image of the vehicle is a two-dimensional image, can be easily acquired, and has a small amount of information, it has less labor and cost than a case where three-dimensional data are used. Therefore, the simulated road generation system 10 can more easily reproduce a road.

<Second Example Embodiment>

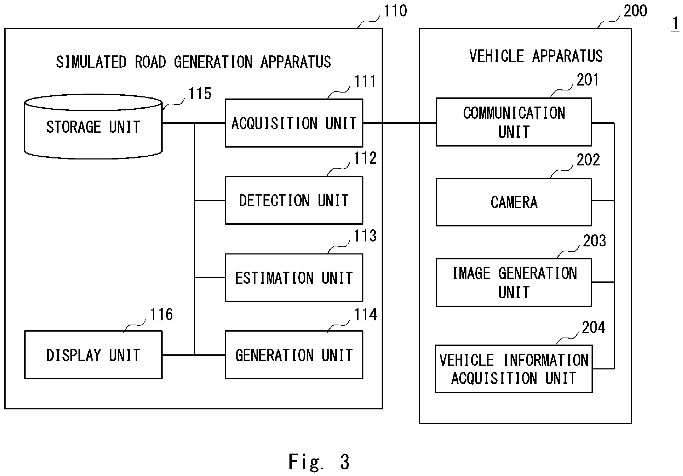

Next, a second example embodiment of the present disclosure will be described. In the second example embodiment, a simulated road generation system (hereinafter, referred to as a simulated road generation apparatus) generates a simulated road in order to cause a vehicle to virtually travel mainly on a simulator. Fig. 3 is a block diagram illustrating a configuration of a system 1 to which the simulated road generation apparatus can be applied.

The system 1 is a computer system that generates a simulated road on a simulator and performs various simulations by using the generated simulated road. The system 1 includes a vehicle apparatus 200 and a simulated road generation apparatus 110, and has a configuration in which the vehicle apparatus 200 and the simulated road generation apparatus 110 are communicably connected to each other via a network (not illustrated). The network is configured in such a way as to include various networks such as the Internet, a wide area network (WAN), a local area network, and a mobile communication network, a dedicated line, or a combination thereof. The network is a wireless communication line, but may be a wired communication line.

(Vehicle apparatus 200)

The vehicle apparatus 200 is a computer apparatus mounted on a vehicle traveling on a road. The vehicle apparatus 200 may function as a drive recorder. The vehicle apparatus 200 acquires a captured image acquired by capturing a scene of a surrounding of the vehicle while the vehicle is traveling, and transmits, as a surrounding image, the captured image or an image generated based on the captured image to the simulated road generation apparatus 110 via the network. The captured image is a two-dimensional image, for example, an RGB image, and includes at least an image region of a demarcation line of a road. In the second example embodiment, a captured image serving as the surrounding image or serving as a basis of the surrounding image is an image captured by a front camera. However, the captured image serving as the surrounding image or serving as the basis of the surrounding image may be an image captured by a rear camera or a side camera instead of the front camera. In addition, a part of the captured image serving as the surrounding image or serving as the basis of the surrounding image may be an image captured by the front camera, and a part of the captured image may be an image captured by the rear camera or the side camera. In addition, the surrounding image generated based on the captured image is, for example, an image acquired by superimposing a predetermined guide line on the captured image. The guide line indicates an outer edge of a region defined by a predetermined width and depth located at a predetermined distance from the vehicle on a real space in a case where the region is projected into the image. In other words, the guide line in the surrounding image is known in length and position on the real space. Hereinafter, the surrounding image will be described as an image in which a predetermined guide line is superimposed on a captured image. In addition, the vehicle apparatus 200 acquires a speed and position information of the vehicle, and transmits the acquired information to the simulated road generation apparatus 110 via the network. The vehicle apparatus 200 includes a communication unit 201, a camera 202, an image generation unit 203, and a vehicle information acquisition unit 204.

The camera 202 is a camera being mounted at any position of a vehicle, captures a scene of a surrounding of the vehicle while the vehicle is traveling, and generates a captured image. In the second example embodiment, the camera 202 is a front camera that captures a scene in front of the vehicle, but may be a rear camera that captures a scene behind the vehicle. The camera 202 generates a captured image of, for example, 10 frames per second (10 fps), and supplies the generated captured image to the image generation unit 203 every 1/10 second.

The image generation unit 203 generates an image in which a guide line having a predetermined size is superimposed on a captured image at a predetermined position, as a surrounding image.

The vehicle information acquisition unit 204 acquires position information of the vehicle and speed information of the vehicle (vehicle speed information). The position information of the vehicle includes at least longitude and latitude, and in addition thereto, may include altitude. Specifically, the vehicle information acquisition unit 204 is connected to a positioning information reception unit (not illustrated) that receives positioning information for positioning a position of the own vehicle from a global navigation satellite system (GNSS), for example, a satellite positioning system such as a global positioning system (GPS), and acquires the position information of the vehicle from the positioning information reception unit. In this case, the position information of the vehicle may be referred to as GPS information. The vehicle information acquisition unit 204 acquires the position information of the vehicle at a predetermined interval, for example, every second. Note that, the position information of the vehicle is not limited to the GPS information, and may be a relative position from a target object whose position information is known. In addition, the vehicle information acquisition unit 204 is connected to an electronic control unit (ECU) of the vehicle via an in-vehicle communication bus such as a controller area network (CAN), and acquires the vehicle speed information from the ECU.

The communication unit 201 is a communication interface with a network. The communication unit 201 transmits, as vehicle data, to the simulated road generation apparatus 110 via the network, a surrounding image, and position information, moving speed (vehicle speed) information, and a capturing time of a vehicle at a time of capturing a captured image serving as a basis of the surrounding image. Hereinafter, a capturing time of a captured image serving as a basis of a surrounding image may be simply referred to as a capturing time of the surrounding image.

(Simulated road generation apparatus 110)

The simulated road generation apparatus 110 is a computer apparatus that generates a simulated road, based on a surrounding image, position information of a vehicle, and vehicle speed information. In the second example embodiment, the simulated road is a model that reproduces a two-dimensional shape or a three-dimensional shape of a road in a predetermined region on the real space. In other words, the simulated road includes a simulated lane in which a shape of a lane included in the predetermined region on the real space is reproduced in two dimensions or three dimensions. The simulated road generation apparatus 110 includes an acquisition unit 111, a detection unit 112, an estimation unit 113, a generation unit 114, a storage unit 115, and a display unit 116.

The acquisition unit 111 is one example of the acquisition unit 11 described above. The acquisition unit 111 includes a communication interface with a network, and acquires vehicle data including a surrounding image, position information of a vehicle, vehicle speed information, and a capturing time from the vehicle apparatus 200 via the network. The acquisition unit 111 supplies the acquired vehicle data to the detection unit 112 and the estimation unit 113. Note that, the acquisition unit 111 may store the acquired vehicle data in the storage unit 115.

The detection unit 112 is one example of the detection unit 12 described above. The detection unit 112 acquires vehicle data from the acquisition unit 111 or the storage unit 115, and detects, by image recognition, at least a demarcation line of a road from a surrounding image included in the vehicle data. Note that, the detection unit 112 may detect another road sign and another vehicle in addition to the demarcation line. The detection unit 112 supplies information of the detected demarcation line of the road to the estimation unit 113.

The estimation unit 113 is one example of the estimation unit 13 described above. The estimation unit 113 generates a road parameter, based on vehicle data acquired from the acquisition unit 111 or the storage unit 115 and information of a demarcation line of a road detected by the detection unit 112. Specifically, the estimation unit 113 determines a divided image region, in a surrounding image, corresponding to a divided region and defined based on the demarcation line, for each divided region formed when a lane on the real space is divided into predetermined divided lengths. The divided length is determined based on a vehicle speed. As one example, the divided region is a region in which a length in a length direction (traveling direction of a vehicle) is the divided length in one lane. Then, as one example, the divided image region may be a substantially rectangular region that has a divided image length in which the length direction is associated to the divided length, and is defined along the demarcation line. Note that, a number of divided image regions differs depending on a number of lanes in the surrounding image. For example, in a case where a demarcation line for three lanes is included in the surrounding image, the estimation unit 113 determines three divided image regions. Therefore, the determined number of divided image regions includes information on the number of lanes.

Then, the estimation unit 113 estimates a divided road parameter for each divided image region, based on the divided image region. The divided road parameter is an individual road parameter indicating at least one of a length of a lane, a width of the lane, and a curve curvature of the divided region. For example, the estimation unit 113 performs projective transformation on the divided image region into a predetermined two-dimensional plane in such a way that the divided image region becomes a top view in a case where a road is looked down from the sky on the real space, and calculates, as the divided road parameter, a length, a width, and a curve curvature of the divided image region after performing the projective transformation. In addition, the estimation unit 113 estimates position information of the divided region, based on position information of the vehicle for each divided image region. At this time, when the simulated road generation apparatus 110 generates a three-dimensional simulated road, the estimation unit 113 may estimate an altitude of the divided region, based on an altitude included in the position information of the vehicle, and add the estimated altitude to the position information. Then, the estimation unit 113 generates a road parameter configured as including the divided road parameter, the position information of the divided region, and the number of divided image regions, based on the divided road parameter, the position information of the divided region, and the number of divided image regions. For example, the estimation unit 113 generates, as a road parameter, information in which the divided road parameter and the position information of the divided region are associated with each other for each divided image region (i.e., each divided region). In other words, the estimation unit 113 generates the road parameter, based on the divided road parameter, the position information of the vehicle at a time of capturing the surrounding image, and the number of divided image regions.

The estimation unit 113 supplies the generated road parameter to the generation unit 114.

The generation unit 114 is one example of the generation unit 14 described above. The generation unit 114 inputs a road parameter to a simulator, and generates a simulated road on the simulator, based on the road parameter. The generation unit 114 causes the display unit 116 to display the generated simulated road.

The storage unit 115 is a storage apparatus that stores information necessary for simulated road generation processing.

The display unit 116 is a display apparatus that displays a simulated road.

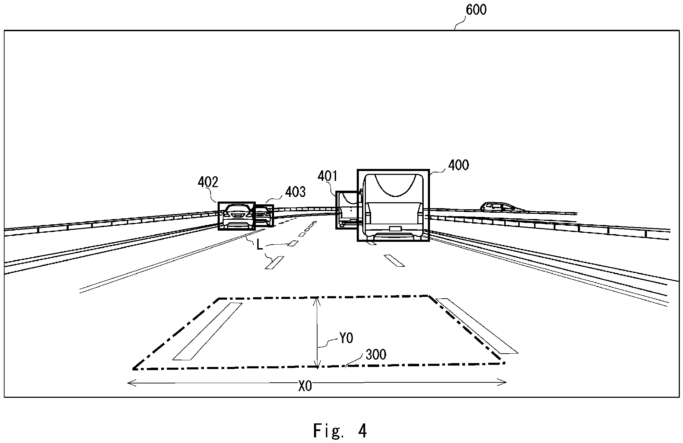

Next, a specific example of a simulated road generation method will be described. Figs. 4 to 9 are diagrams for describing the simulated road generation method according to the second example embodiment.

First, Fig. 4 illustrates a surrounding image 600 acquired from the vehicle apparatus 200 by the simulated road generation apparatus 110. The surrounding image 600 includes a demarcation line L of a road, and other vehicles 400 to 403. Since the other vehicles 400 to 403 traveling in front of a vehicle shield a distant demarcation line, it is in a state where the distant demarcation line cannot be visually recognized. Note that, a guide line 300 is superimposed on the surrounding image 600. The guide line 300 indicates, for example, a region acquired by projecting a rectangular region having a width of 3.5 meter and a depth of 8 meter on the real space into an image space. In other words, a width X0 of the guide line 300 is equivalent to the width 3.5 meter on the real space, and a depth Y0 of the guide line 300 is equivalent to the depth 8 meter on the real space.

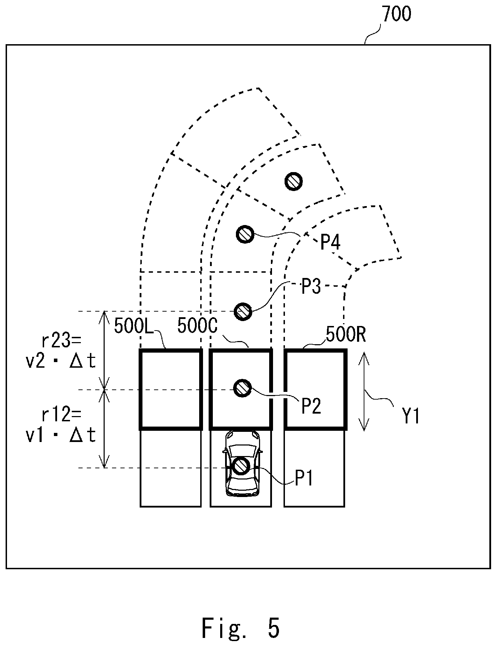

Herein, Fig. 5 illustrates an image 700 in a top view in a case where a lane is looked down from the sky on the real space at a time of capturing the surrounding image 600. In the present figure, the demarcation line and the other vehicles are omitted for a purpose of description. Points P1, P2, P3, and P4 in the present figure indicate positions when the vehicle acquires position information. Since the vehicle acquires position information at every predetermined interval $\Delta t$, a distance between each point is represented by a vehicle speed v and the interval $\Delta t$. For example, when the vehicle speed at the point P1 is v1, the distance between the points P1 and P2 is represented by $r12 \approx v1 \cdot \Delta t$. In addition, when the vehicle speed at the point P2 is v2, the distance between the points P2 and P3 is represented by $r23 \approx v2 \cdot \Delta t$.

Herein, as illustrated in the present figure, the vehicle is located at the point P1 at the time of capturing the surrounding image 600. At this time, the estimation unit 113 defines three regions surrounded by a thick line having a divided length Y1 in the length direction around the point P2, as divided regions 500C, 500R, and 500L.

For example, the divided length Y1 is represented as follows by using the vehicle speed at a time of locating at points P1 and P2, and the interval $\Delta t$.

$$Y1 = (v1 \cdot \Delta t + v2 \cdot \Delta t)/2 = (v1 + v2) \cdot \Delta t/2$$

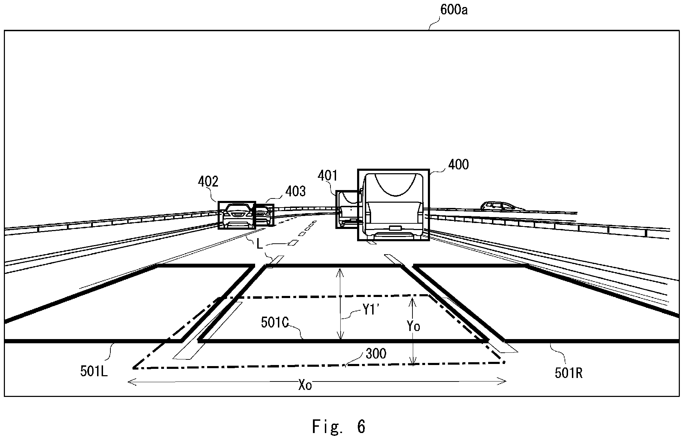

Herein, an image 600a illustrated in Fig. 6 indicates divided image regions 501C, 501R, and 501L determined from the surrounding image 600 by the estimation unit 113. The divided image regions 501C, 501R, and 501L are image regions corresponding to the divided regions 500C, 500R, and 500L on the real space illustrated in Fig. 5. Therefore, a depth Y1' of the divided image region 501C corresponds to the divided length Y1 on the real space.

Note that, in order for the estimation unit 113 to calculate the length of the depth Y1', corresponding to the divided length Y1 on the real space, of the divided image region 501C in the surrounding image, and a position of the divided image region 501C in the surrounding image, there are two types of methods. The first is to use the guide line 300 being known in size and position on the real space. In this case, the estimation unit 113 determines the depth Y' of the divided image region 501C corresponding to the divided region 500C and the position of the divided image region 501C in the surrounding image, based on the size (e.g., a width Xo, and a depth Yo) and the position of the guide line 300 in the surrounding image. The second is to use an image region of another vehicle in the surrounding image. A size of the another vehicle on the real space is known for each vehicle type. Therefore, the estimation unit 113 determines the depth Y' of the divided image region 501C corresponding to the divided region 500C and the position of the divided image region 501C in the surrounding image, based on the size and the position of the image region of the another vehicle in the surrounding image. In addition, in Fig. 6, a width of the divided image region 501C is determined based on the demarcation line in the surrounding image detected by the detection unit 112. When the demarcation line is a broken line as illustrated in Fig. 6, the estimation unit 113 may determine a line connecting adjacent demarcation lines to each other as a pair of sides defining the width of the substantially rectangular region in the divided image region 501C, and determine the divided image region 501C. Then, when there is a lane on a right side and a left side of the divided image region 501C of the surrounding image, the estimation unit 113 determines the divided image regions 501R and 501L on the right side and the left side of the divided image region 501C, based on the demarcation line. In addition, when there are four or more lanes, that is, when there is a lane outside (an opposite side to the divided image region 501C) the divided image regions 501R and 501L of the surrounding image, the estimation unit 113 may also determine the outside divided image region, based on the demarcation line.

Then, a length of the outer edge, a width of the outer edge, an angle formed by the outer edge, the curve curvature, or the like of the determined divided image regions 501C, 501R, and 501L correspond to the divided road parameters in the divided image regions. Specifically, first, the estimation unit 113 performs projective transformation on the determined divided image region into a predetermined two-dimensional plane, for example, a plane in a case where visually recognizing from the sky as illustrated in Fig. 5. Then, the estimation unit 113 measures, as the divided road parameters of the divided image region, the length of the outer edge (i.e., a length of the lane), the width of the outer edge (i.e., a width of the lane), the angle formed by the outer edge, the curve curvature, or the like of the divided image region after performing the projective transformation.

From the divided road parameter associated to one divided image region estimated in such manner, one lane block in which one lane is divided can be generated on a simulator. Where to place the generated lane block on the simulator can be determined based on the position information of the vehicle at a time of capturing the surrounding image. Therefore, the estimation unit 113 generates a road parameter for each divided image region, based on the divided road parameter and the position information of the vehicle at the time of capturing the surrounding image associated to the divided image region. More specifically, the estimation unit 113 may generate, for each divided image region, information including the divided road parameter and position information of the lane block determined based on the position information of the vehicle, as the road parameter. Note that, when a three-dimensional simulated road is generated on the simulator, the estimation unit 113 may include altitude information of the lane block determined based on the altitude of the vehicle in the position information of the lane block. As a result, the simulated road generation apparatus 110 can easily generate a simulated road without using map information.

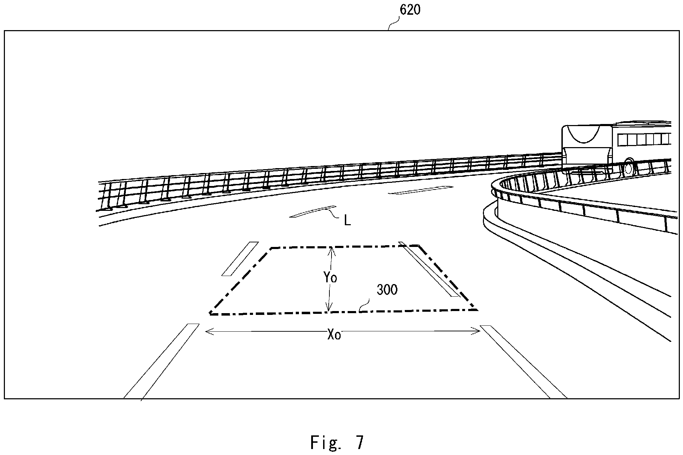

Next, Fig. 7 illustrates a surrounding image 620 captured when the vehicle is located at the point P3. As illustrated in the present figure, a lane is greatly curved to a right. The surrounding image 620 also includes the demarcation line L of the road and the guide line 300.

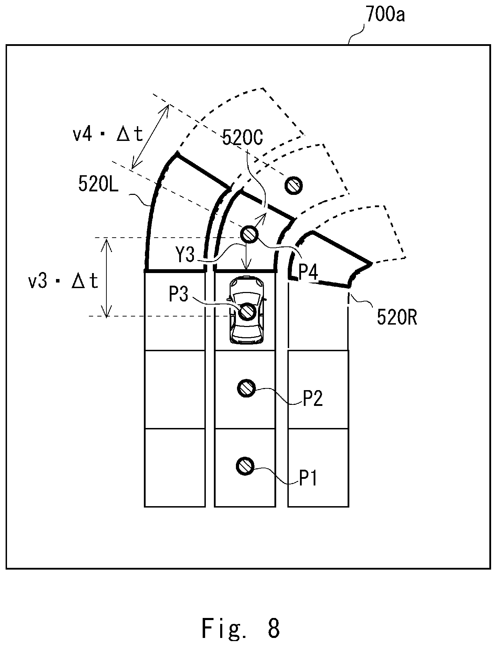

Herein, Fig. 8 illustrates an image 700a in a top view in a case where the lane is looked down from the sky on the real space at a time of capturing the surrounding image 620. The estimation unit 113 defines a region surrounded by a thick line having a divided length Y3 in the length direction around the point P4, as a divided region 520C, and defines adjacent regions as divided regions 520R and 520L.

For example, the divided length Y3 is represented as follows by using the vehicle speed when the vehicle is located at points P3 and P4, and the interval $\Delta t$.

$$Y3 = (v3 \cdot \Delta t + v4 \cdot \Delta t)/2 = (v3 + v4) \cdot \Delta t/2$$

Note that, v3 is the vehicle speed at the point P3, and v4 is the vehicle speed at the point P4.

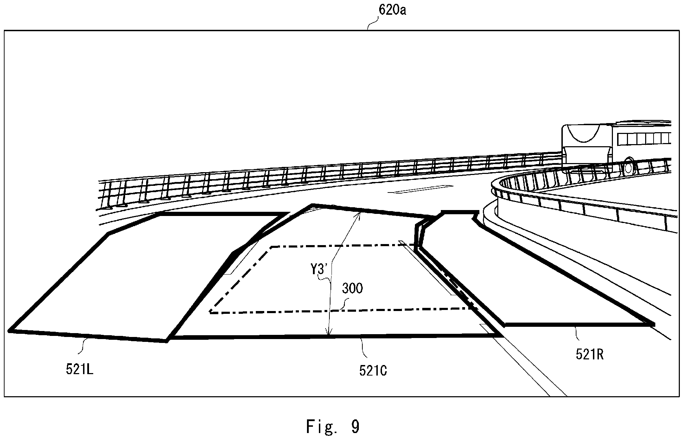

Herein, an image 620a illustrated in Fig. 9 indicates divided image regions 521C, 521R, and 521L determined from the surrounding image 620 by the estimation unit 113. The divided image regions 521C, 521R, and 521L are image regions corresponding to the divided regions 520C, 520R, and 520L on the real space illustrated in Fig. 8. Therefore, a depth Y3' of the divided image region 521C corresponds to the divided length Y3 on the real space. Similarly to the divided image regions 501C, 501R, and 501L, the estimation unit 113 estimates the divided road parameter for the divided image regions 521C, 521R, and 521L. Then, the estimation unit 113 generates a road parameter, based on the divided road parameter of each divided image region, and the position information of the vehicle at a time of capturing the surrounding image associated to the divided image region.

As described above, the simulated road generation apparatus 110 generates a divided road parameter for each divided region acquired by dividing a lane, and generates a road parameter from the generated divided road parameter. As a result, in the surrounding image 600, even when information of a distant demarcation line cannot be visually recognized due to presence of another vehicle, the road parameter can be generated from information of a demarcation line of another surrounding image 620 being equivalent to the demarcation line that cannot be visually recognized.

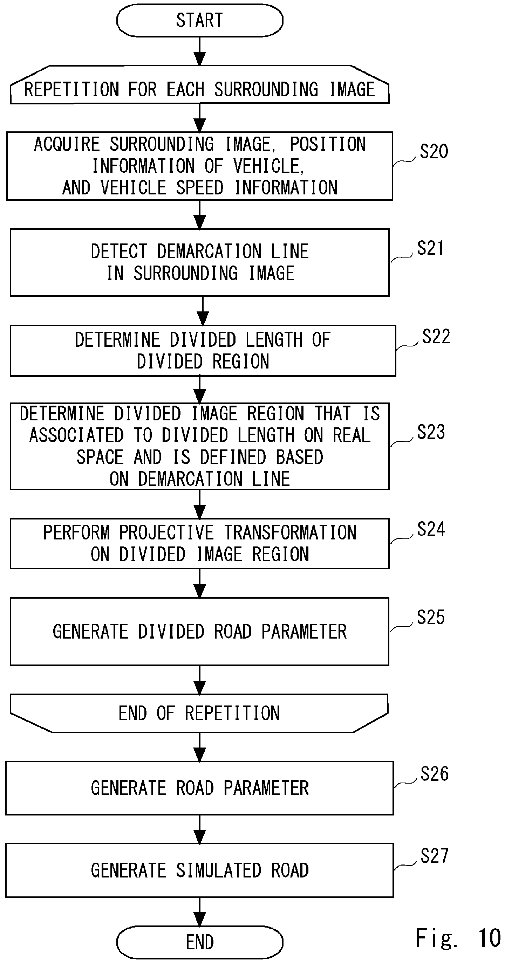

Fig. 10 is a flowchart illustrating one example of a flow of the simulated road generation method according to the second example embodiment. First, the simulated road generation apparatus 110 repeats processing illustrated in steps S20 to S25 for each of surrounding images in order from the surrounding image having an earlier capturing time. Note that, the surrounding image is captured every interval $\Delta t$ at which the vehicle apparatus 200 acquires position information of a vehicle.

First, the detection unit 112 of the simulated road generation apparatus 110 acquires a surrounding image, position information of the vehicle, and vehicle speed information from the acquisition unit 111 or the storage unit 115 (step S20). Then, the detection unit 112 detects a demarcation line from the surrounding image (step S21). Then, the estimation unit 113 determines a divided length of a divided region defined on the real space, based on the vehicle speed information and the interval $\Delta t$ (step S22). Next, the estimation unit 113 determines a divided image region, in the surrounding image, that has a length associated to the divided length and is defined based on the demarcation line (step S23). Note that, step S21 described above may be performed in parallel with step S23. In other words, the estimation unit 113 may detect the demarcation line, in the surrounding image, from a predetermined image region having a length associated to the divided length, and determine the divided image region in such a way as to be defined by the demarcation line. Subsequently, the estimation unit 113 performs projective transformation on the divided image region into a predetermined two-dimensional plane (step S24). Then, the estimation unit 113 generates a divided road parameter, based on a shape of the divided image region acquired by performing the projective transformation (step S25).

In step S26, the estimation unit 113 generates a road parameter, based on the divided road parameter of each divided image region, and the position information of the vehicle at the time of capturing the surrounding image associated to the divided image region. Then, in step S27, the generation unit 114 inputs the generated road parameter to a simulator, and generates a simulated road on the simulator. At this time, the generation unit 114 may display the generated simulated road on the display unit 116. For example, the generation unit 114 may display an image similar to the image 700a in Fig. 8 on the display unit 116 as a simulated road.

Then, the generated simulated road may be used for a traveling simulation of a vehicle. For example, the simulated road generation apparatus 110 may virtually reproduce traveling of an own vehicle on the simulated road generated on the simulator, based on a history of GPS information when the own vehicle travels on an actual road. As a result, behavior of the own vehicle can be grasped and analyzed in detail. For example, the behavior of the own vehicle can be grasped from an angle different from an actual camera, and a danger can be estimated. In addition, the simulated road generation apparatus 110 may virtually reproduce traveling of another vehicle on the simulated road on the simulator, based on a detection result of the another vehicle in the surrounding image. As a result, a relationship between the own vehicle and the another vehicle, and a relationship between the other vehicles can be grasped and analyzed in detail as well. In other words, it is possible to accurately grasp information such as a road shape, a position of the own vehicle, and a position of the another vehicle during traveling by the traveling simulation, and to virtually reproduce a situation of a surrounding at the moment. The traveling simulation may be used, for example, in development of a vehicle. As one example, when it is desired to verify a situation when a malfunction occurs in a vehicle (e.g., an autonomous driving vehicle) in a middle of development, verification of the situation under the same conditions and an experiment after correction are performed on the simulator, and thereby costs of the verification and the experiment can be reduced.

Note that, a road parameter includes information on the number of divided image regions, that is, information on the number of lanes. Therefore, the road parameter also includes information on an increase/decrease section of the number of lanes.

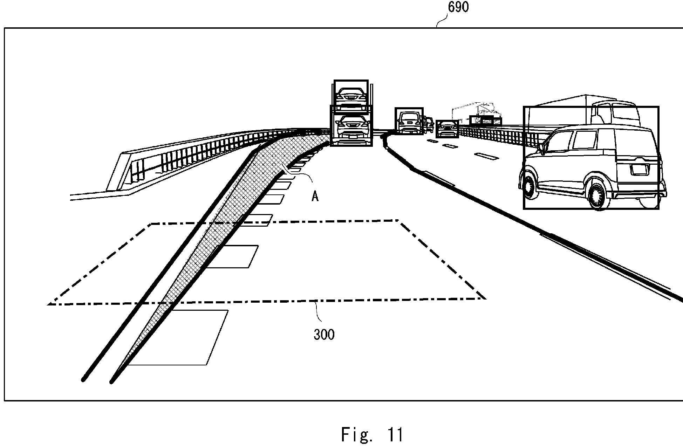

Fig. 11 is a diagram illustrating one example of a surrounding image 690 according to the second example embodiment. The surrounding image 690 includes an increase region A of the number of lanes. The simulated road generation apparatus 110 can generate a road parameter reflecting an increase section of the number of lanes by executing the above-described simulated road generation method by using a surrounding image captured around a capturing time of the surrounding image 690.

As described above, the simulated road generation apparatus 110 according to the second example embodiment automatically generates a road parameter necessary for road reproduction, based on a surrounding image of a vehicle, position information of the vehicle, and vehicle speed information, and sets the generated road parameter as an input of the simulator. Therefore, the simulated road generation apparatus 110 can easily reproduce a road without requiring work of acquiring map information, calculating and inputting a parameter. When a wide region road is reproduced, an amount of map information to be acquired and an amount of parameters to be calculated and input become enormous, but the simulated road generation apparatus 110 can more remarkably acquire an effect of reducing labor and a cost.

Note that, since the surrounding image of the vehicle is a two-dimensional image, can be easily acquired, and has a small amount of information, it has less labor and cost than a three-dimensional data. Therefore, the simulated road generation apparatus 110 can more easily reproduce a road.

In addition, since the simulated road generation apparatus 110 uses a surrounding image captured from an in-vehicle camera, it is possible to reproduce a precise road with a fine granularity in a vehicle unit. Then, by causing a vehicle to travel on the reproduced road, a precise traveling simulation can be performed. As a result, a development cost of the vehicle can be reduced.

<Third Example Embodiment>

Next, a third example embodiment of the present disclosure will be described. In the third example embodiment, a simulated road generation apparatus is characterized in that a road parameter associated to a predetermined image region in a surrounding image captured at any time point is corrected based on a surrounding image captured later than that time point. A simulated road generated by the corrected road parameter may be mainly used to detect a dangerous event associated with another vehicle from a surrounding image capturing a surrounding of a vehicle on a real space.

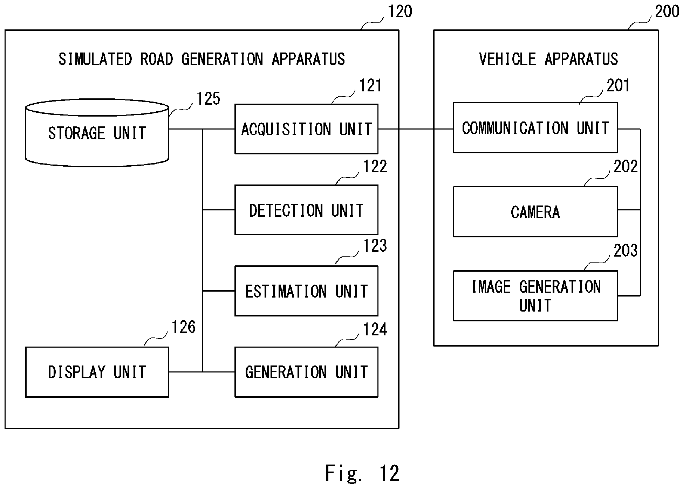

Fig. 12 is a block diagram illustrating a configuration of a system 2 according to the third example embodiment. The system 2 is a computer system that generates a simulated road associated to a predetermined image region included in a surrounding image captured at any time point. In the following, the system 2 will be described as generating a simulated road for detecting a dangerous event associated with another vehicle, but a purpose is not limited thereto.

Note that, the dangerous event related to another vehicle may be dangerous driving such as dangerous interruption, meandering driving, or tailgating driving of the another vehicle. The system 2 has basically a similar configuration to that of the system 1, but includes a simulated road generation apparatus 120 instead of the simulated road generation apparatus 110.

The simulated road generation apparatus 120 includes an acquisition unit 121, a detection unit 122, an estimation unit 123, a generation unit 124, a storage unit 125, and a display unit 126.

The acquisition unit 121 is one example of the acquisition unit 11 described above, and corresponds to the acquisition unit 111 described above. The acquisition unit 121 includes a communication interface with a network, and acquires vehicle data including a surrounding image, position information of a vehicle, vehicle speed information, and a capturing time, from a vehicle apparatus 200 via the network. Herein, among the surrounding images captured successively, a surrounding image, being captured at any time, to be a target of dangerous event detection is referred to as a first frame, and a surrounding image captured later than the first frame is referred to as a second frame. The acquisition unit 121 acquires, as vehicle data, a plurality of frames including the first and second frames, and position information of the vehicle, vehicle speed information, and a capturing time at a time of capturing each frame. Note that, when a frame (surrounding image) is generated based on a captured image, the capturing time refers to a capturing time of the captured image serving as a basis of the frame.

The detection unit 122 is one example of the detection unit 12 described above, and corresponds to the detection unit 112 described above. The detection unit 122 detects a demarcation line of a road for the first frame. Then, the detection unit 122 supplies information of the demarcation line for the first frame to the estimation unit 123. Herein, the detection unit 122 decides whether a demarcation line is not detected in the first frame, that is, whether there is a shielded region where a demarcation line is shielded by an obstacle object. The obstacle object may be another vehicle or a road wall. When it is decided that there is a shielded region, the detection unit 122 detects a demarcation line of a road for the second frame being captured in a vicinity of the shielded region in the real space and capturing the shielded region. Then, the detection unit 122 supplies information of the demarcation line for the second frame to the estimation unit 123.

The estimation unit 123 is one example of the estimation unit 13 described above, and corresponds to the estimation unit 113 described above. The estimation unit 123 estimates a first road parameter, based on at least the information of the demarcation line of the second frame, and the position information of the vehicle at a time of capturing each of the first and second frames. The first road parameter is a road parameter of a region included in the first frame. The first road parameter may be a road parameter of a non-shielded region and a shielded region included in the first frame. In addition, the first road parameter may be a road parameter of only the shielded region included in the first frame, that is, a road parameter included in the first frame and not including a road parameter of the non-shielded region. Herein, when the first road parameter is the road parameter of the non-shielded region and the shielded region included in the first frame, the following processing may be performed. For example, first, the estimation unit 123 estimates, for the second frame, a second road parameter being the road parameter of the shielded region, based on the position information of the vehicle and the demarcation line at a time of capturing. Specifically, the estimation unit 123 estimates an individual road parameter of the shielded region included in the second frame, based on the demarcation line of a region being equivalent to the shielded region in the second frame. The estimation unit 123 generates the second road parameter, based on the individual road parameter of the shielded region, and the position information of the vehicle at a time of capturing the second frame. In addition, the estimation unit 123 estimates, for the first frame, the first road parameter being a road parameter of a region included in the first frame, based on the position information of the vehicle and the demarcation line at the time of capturing. Then, the estimation unit 123 corrects the first road parameter, based on the second road parameter. The correction may be reworded to expansion or interpolation. In addition, when the first road parameter is a road parameter of only the shielded region included in the first frame, the estimation unit 123 generates, as the first road parameter, a road parameter used when the shielded region included in the second frame is projected onto the first frame. In this case, the estimation unit 123 generates the first road parameter, based on the individual road parameter of the shielded region included in the second frame, and the position information of the vehicle at a time of capturing the first and second frames.

The generation unit 124 is one example of the generation unit 14 described above, and inputs the generated first road parameter to a simulator, generates a demarcation line in a predetermined space on the simulator, based on the first road parameter, and generates a simulated road. For example, the generation unit 124 causes a lane generated based on the first road parameter to be performed projective transformation into a field of view of the first frame. As a result, it is possible to generate a simulated road that could be visually recognized when there were no obstacle object in the field of view of the first frame. Then, the generation unit 124 may generate, as a simulated road, a superimposed image in which the lane generated based on the first road parameter is superimposed on the first frame.

The storage unit 125 has a similar function to that of the storage unit 115 described above. In addition, the display unit 126 has a similar function to that of the display unit 116 described above.

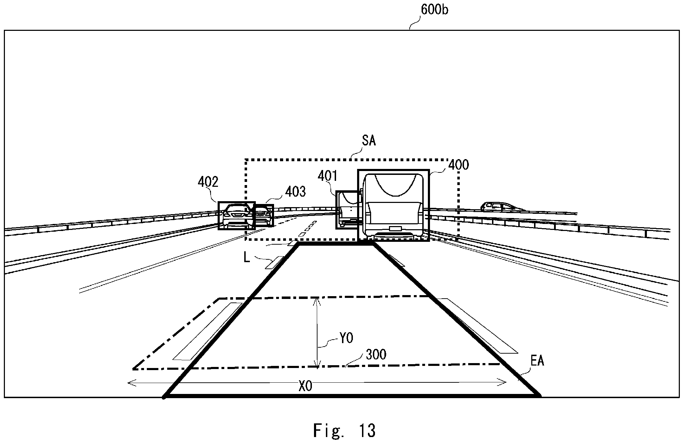

Figs. 13 to 15 are diagrams for describing a simulated road generation method according to the third example embodiment. Hereinafter, a case where the first road parameter is a road parameter of the non-shielded region and the shielded region included in the first frame will be described. An image 600b illustrated in Fig. 13 indicates a non-shielded region EA and a shielded region SA in a case where the surrounding image 600 illustrated in Fig. 4 is a first frame. In the present figure, a distant demarcation line is shielded by presence of another vehicle 400, another vehicle 401, and a road wall of a curved road, and the shielded region SA is formed. For example, the estimation unit 123 determines, for the first frame, the non-shielded region EA excluding the shielded region SA as the above-described divided image region. Note that, the divided image region is defined by a demarcation line. In the present figure, although the divided image region is determined only in a lane on which a vehicle travels, the divided image region may be determined for each lane. Then, the estimation unit 123 performs projective transformation on the divided image region into a predetermined two-dimensional plane, and calculates a length, a width, and a curve curvature of the lane of the divided image region acquired by performing the projective transformation, as an individual road parameter of the non-shielded region EA. The predetermined two-dimensional plane may be a plane in a case where a lane is looked down from the sky on the real space as illustrated in Fig. 5, or may be the same as a plane indicating the field of view of the first frame. Then, the estimation unit 123 calculates, provisionally as the first road parameter, information in which the calculated individual road parameter of the non-shielded region EA is associated with the position information of the vehicle at a time of capturing the first frame.

Then, the estimation unit 123 estimates a distance from the vehicle to the shielded region SA by using a guide line 300 whose size and position are known. A size and position of another vehicle included in the surrounding image 600 may be used for estimating the distance from the vehicle to the shielded region SA. The estimation unit 123 estimates the position information of the vehicle at a time of capturing a vicinity of the shielded region SA (i.e., the second frame), based on the position information of the vehicle at a time of capturing the surrounding image 600 and the distance from the vehicle to the shielded region SA. Alternatively, the estimation unit 123 estimates a capturing time at a time of capturing the second frame, based on the vehicle speed information of the vehicle at the time of capturing the surrounding image 600 and the distance from the vehicle to the shielded region SA. In this way, the estimation unit 123 can determine the second frame.

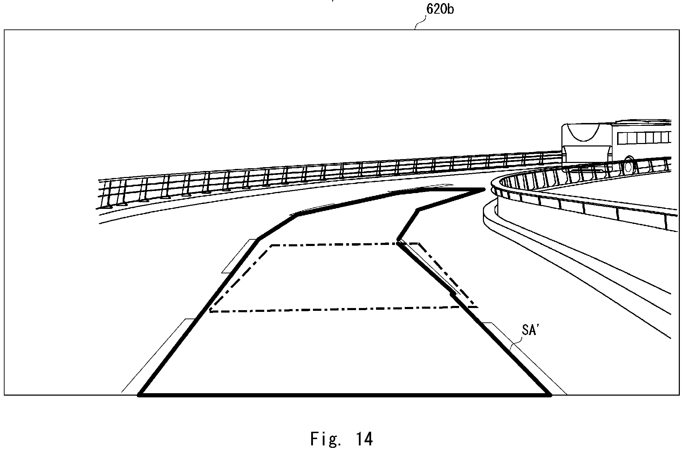

An image 620b illustrated in Fig. 14 indicates a region SA' being equivalent to the shielded region SA in a case where the surrounding image 620 illustrated in Fig. 7 is the second frame. The estimation unit 123 determines, for the second frame, the region SA' being equivalent to the shielded region SA as the divided image region described above. Also in this case, the divided image region is defined by a demarcation line. Also in the present figure, although the divided image region is determined only in a lane on which a vehicle travels, the divided image region may be determined for each lane. The estimation unit 123 performs projective transformation on the divided image region into a two-dimensional plane similar to that in a case where the first road parameter is provisionally calculated, and calculates a length, a width, and a curve curvature of the lane of the divided image region acquired by performing the projective transformation, as an individual road parameter of the shielded region SA. Then, the estimation unit 123 calculates, as the second road parameter, information in which the calculated individual road parameter of the shielded region SA is associated with the position information of the vehicle at a time of capturing the second frame.

Then, the estimation unit 123 corrects the first road parameter, based on the second road parameter. For example, the estimation unit 123 corrects the first road parameter by integrating the second road parameter associated with the position information of the vehicle at a time of capturing the second frame into the first road parameter associated with the position information of the vehicle at a time of capturing the first frame.

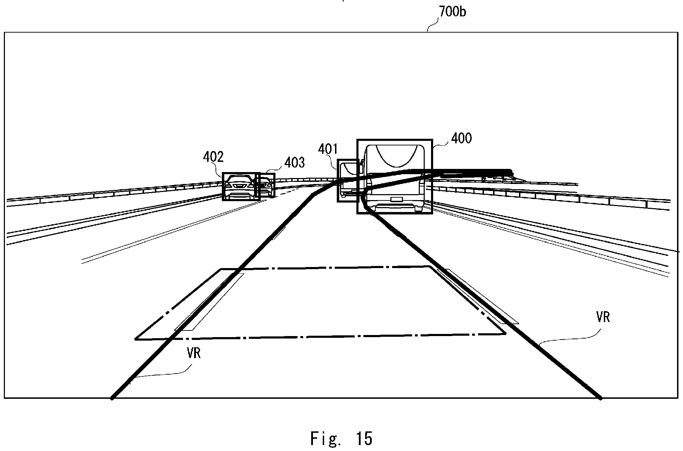

An image 700b illustrated in Fig. 15 indicates a simulated road in which a lane generated by using the first road parameter after correction is projected onto a field of view of the surrounding image 600 being the first frame. Specifically, the generation unit 124 performs projective transformation on the lane generated by using the first road parameter after correction into the field of view of the first frame, and superimposes the lane acquired by performing the projective transformation on the first frame. As a result, it is possible to generate a simulated road that could be visually recognized when there were no obstacle object in the field of view of the first frame. Note that, when the two-dimensional plane used in the calculation of the first and second road parameters is the same as the plane indicating the field of view of the first frame, performing the projective transformation of the lane may be omitted.

According to the image 700b illustrated in Fig. 15, that is, the simulated road, it can be seen that another vehicle 401 is traveling across a lane. In addition, it can be seen that another vehicle 400 is traveling to a left of the lane.

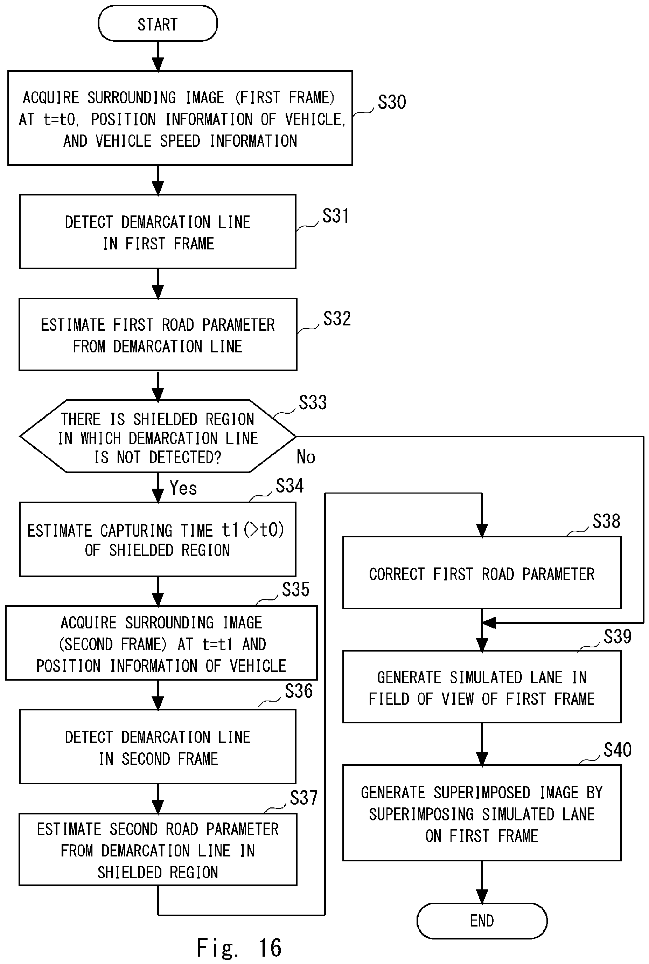

Fig. 16 is a flowchart illustrating one example of a flow of the simulated road generation method according to the third example embodiment. First, the detection unit 122 of the simulated road generation apparatus 120 acquires, from the acquisition unit 121 or the storage unit 125, a surrounding image at a capturing time t=t0, position information of a vehicle, and vehicle speed information (step S30). The surrounding image at the capturing time t=t0 is the first frame. Then, the detection unit 122 detects a demarcation line from the first frame (step S31). Next, the estimation unit 123 determines a non-shielded region in the first frame, and provisionally estimates a first road parameter, based on the demarcation line of the non-shielded region and the position information of the vehicle at a time of capturing the first frame (step S32). Subsequently, the estimation unit 123 decides whether there is a shielded region in which a demarcation line is not detected in the first frame (step S33). When it is not decided that there is a shielded region (No in step S33), the estimation unit 123 proceeds processing to step S39.

On the other hand, when it is decided that there is a shielded region (Yes in step S33), the estimation unit 123 estimates the capturing time t=t1 (>t0) of a surrounding image acquired by capturing a vicinity of the shielded region by using the vehicle speed information (step S34). The surrounding image acquired by capturing the vicinity of the shielded region is the second frame. The detection unit 122 acquires, from the acquisition unit 121 or the storage unit 125, the second frame being the surrounding image at the capturing time t=t1 and the position information of the vehicle (step S35). Then, similarly to the first frame, the detection unit 122 detects a demarcation line also for the second frame (step S36). Subsequently, the estimation unit 123 estimates a second road parameter, based on a demarcation line of a region corresponding to the shielded region of the second frame and the position information of the vehicle at the time of capturing the second frame (step S37). Next, the estimation unit 123 corrects the first road parameter, based on the second road parameter (step S38). Then, the generation unit 124 generates a lane by using the first road parameter after correction, and generates a simulated lane by projecting the generated lane into the field of view of the surrounding image 600 being the first frame (step S39). Then, the generation unit 124 generates a superimposed image by superimposing the simulated lane on the first frame (step S40).

Note that, the above description is a case where the first road parameter is a road parameter of the non-shielded region and the shielded region included in the first frame. However, when it is assumed that the first road parameter is a road parameter of the shielded region included in the first frame, the estimation unit 123 first calculates the individual road parameter of the shielded region from the demarcation line of the shielded region included in the second frame. Then, the estimation unit 123 determines a position where the simulated lane associated to the shielded region is superimposed in the first frame, based on the position information of the vehicle at a time of capturing the first and second frames. The estimation unit 123 generates the first road parameter including the individual road parameter of the shielded region included in the second frame and information of the superimposed position. Then, the generation unit 124 generates a simulated lane in the shielded region, based on the first road parameter, performs projective transformation on the generated simulated lane into the field of view of the first frame, and superimposes the simulated lane being performed projective transformation and associated to the shielded region on the superimposed position of the first frame. Therefore, in this case, generation and superimposition of a simulated lane associated to the non-shielded region are omitted.

As described above, the third example embodiment can achieve a similar effect to that of the second example embodiment. In addition, according to the third example embodiment, since only information being insufficient in a target frame is acquired from a future frame and applied, it is possible to efficiently generate necessary information. Therefore, a processing speed is improved.

Note that, the simulated road generation apparatus 120 may transmit data of a generated simulated road to the vehicle apparatus 200. Then, the vehicle apparatus 200 that has received the data of the simulated road may cause a display unit (not illustrated) to display the simulated road. As a result, a crew member of a vehicle of the vehicle apparatus 200 can easily grasp a road situation before a predetermined time. Alternatively, the vehicle apparatus 200 may store the received data of the simulated road in an external storage apparatus (not illustrated). Then, a relevant person of the vehicle apparatus 200 provides the data of the simulated road stored in the external storage apparatus to a police agency or an insurance company, and thereby it is possible to easily provide information on an incident or an accident.

<Fourth Example Embodiment>

Next, a fourth example embodiment of the present disclosure will be described. In the fourth example embodiment, a simulated road generation apparatus detects a dangerous event related to another vehicle from a surrounding image acquired by capturing a surrounding of a vehicle on a real space by using a simulated road.

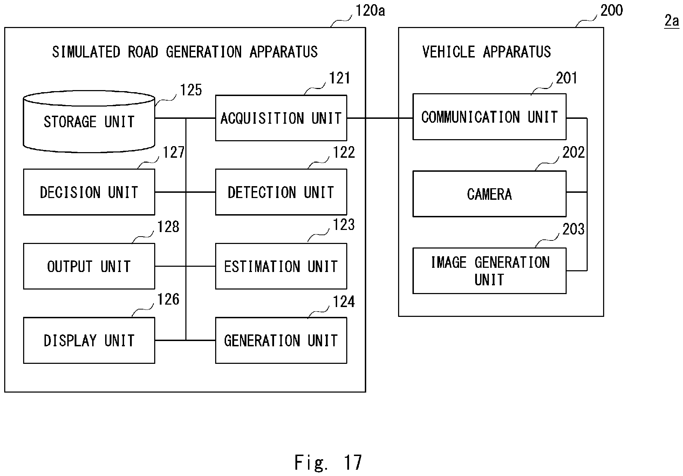

Fig. 17 is a block diagram illustrating a configuration of a system 2a according to the fourth example embodiment. The system 2a has basically a similar configuration and function to those of the system 2, but includes a simulated road generation apparatus 120a instead of the simulated road generation apparatus 120. The simulated road generation apparatus 120a includes a decision unit 127 and an output unit 128 in addition to a configuration of the simulated road generation apparatus 120.

The decision unit 127 detects a dangerous event related to another vehicle, based on a simulated road generated by a generation unit 124. For example, the dangerous event related to another vehicle is dangerous driving such as dangerous interruption, meandering driving, or tailgating driving of the another vehicle, and the decision unit 127 decides whether another vehicle is performing dangerous driving, based on an image region of a lane and the another vehicle included in a superimposed image.

The output unit 128 outputs a decision result by the decision unit 127. The output unit 128 may be integrally formed with a display unit 126.

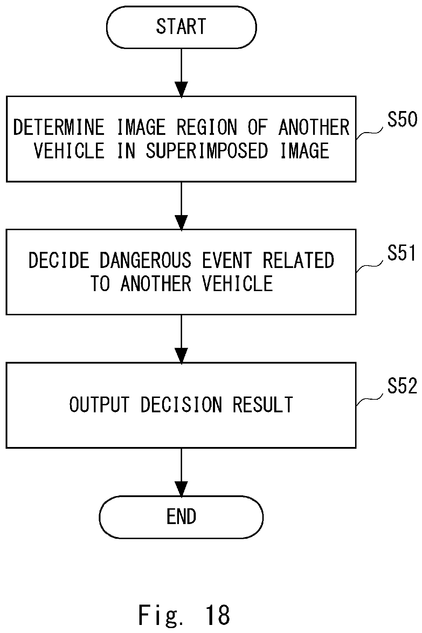

Fig. 18 is a flowchart illustrating a flow of a decision method according to the fourth example embodiment. First, the decision unit 127 of the simulated road generation apparatus 120a acquires a superimposed image generated as a simulated road by the generation unit 124, and determines an image region of another vehicle included in the acquired superimposed image (step S50). Then, the decision unit 127 decides whether a dangerous event related to the another vehicle exists, based on a position of a lane and a position of the image region of the another vehicle included in the superimposed image (step S51). At this time, the decision unit 127 may decide a type of the dangerous event, in addition to presence or absence of the dangerous event. Note that, the decision unit 127 may detect a movement of the another vehicle, based on the position of the lane and the position of the image area of the another vehicle in the superimposed image generated for a plurality of frames, and decide presence or absence of the dangerous event related to the another vehicle. As a result, it is possible to detect dangerous interruption, meandering driving, or tailgating driving of the another vehicle. Then, the output unit 128 outputs a decision result in a predetermined format (step S52).

Note that, the output unit 128 may provide information by transmitting information on a dangerous event related to another vehicle to a computer (not illustrated) of a police agency or an insurance company via a network.

As described above, the simulated road generation apparatus 120a according to the fourth example embodiment can detect a dangerous event related to another vehicle by using a simulated road. Note that, the simulated road generation apparatus 120a may transmit data of a superimposed image in which the dangerous event is detected to a vehicle apparatus 200 in response to detection of the dangerous event. The vehicle apparatus 200 that has received the data of the superimposed image may cause a display unit (not illustrated) to display the superimposed image. As a result, a crew member of a vehicle of the vehicle apparatus 200 can easily grasp the dangerous event before a predetermined time. Alternatively, the vehicle apparatus 200 may store the received data of the superimposed image in an external storage apparatus (not illustrated). Then, a relevant person of the vehicle apparatus 200 provides the data of the simulated road stored in the external storage apparatus to a police agency or an insurance company, and thereby it is possible to more easily provide information on an incident or an accident.

Subsequently, a physical configuration of a simulated road generation apparatus and a vehicle apparatus will be described. Fig. 18 is a diagram illustrating a configuration example of a computer that can be used as the simulated road generation apparatus and the vehicle apparatus. A computer 1000 includes a processor 1010, a storage unit 1020, a read only memory (ROM) 1030, a random access memory (RAM) 1040, a communication interface (IF) 1050, and a user interface 1060.

The communication interface 1050 is an interface for connecting the computer 1000 and a communication network to each other via a wired communication means, a wireless communication means, or the like. The user interface 1060 includes, for example, a display unit such as a display. In addition, the user interface 1060 includes an input unit such as a keyboard, a mouse, and a touch panel.

The storage unit 1020 is an auxiliary storage apparatus capable of holding various types of pieces of data. The storage unit 1020 is not necessarily a part of the computer 1000, and may be an external storage apparatus, or a cloud storage connected to the computer 1000 via a network.

The ROM 1030 is a nonvolatile storage apparatus. For example, a semiconductor memory apparatus such as a flash memory having a relatively small capacity is used for the ROM 1030. A program executed by the processor 1010 may be stored in the storage unit 1020 or the ROM 1030. The storage unit 1020 or the ROM 1030 stores, for example, various programs for achieving a function of each unit in the simulated road generation apparatus and the vehicle apparatus.

The above-described program can be stored by using non-transitory computer-readable media of various types, and supplied to the computer 1000. The non-transitory computer-readable medium includes a tangible storage media of various types. Examples of the non-transitory computer-readable medium include a magnetic recording medium such as, for example, a flexible disk, a magnetic tape, or a hard disk, a magneto-optical recording medium such as, for example, a magneto-optical disk, an optical disk medium such as a compact disc (CD), or a digital versatile disk (DVD), and a semi-conductor memory such as a mask ROM, a programmable ROM (PROM), an erasable PROM (EPROM), a flash ROM, or a RAM. In addition, a program may also be supplied to a computer by using transitory computer-readable media of various types. Examples of the transitory computer-readable medium include an electrical signal, an optical signal, and an electromagnetic wave. The transitory computer-readable medium can supply the program to the computer via a wired communication path such as an electric wire and an optical fiber, or a wireless communication path.

The RAM 1040 is a volatile storage apparatus. Various types of semiconductor memory devices such as a dynamic random access memory (DRAM) or a static random access memory (SRAM) are used for the RAM 1040. The RAM 1040 may be used as an internal buffer temporarily storing data and the like. The processor 1010 loads a program stored in the storage unit 1020 or the ROM 1030 into the RAM 1040, and executes the loaded program. The processor 1010 may be a central processing unit (CPU) or a graphics processing unit (GPU). By executing the program by the processor 1010, a function of each unit in the simulated road generation apparatus and the vehicle apparatus can be achieved. The processor 1010 may have an internal buffer capable of temporarily storing data and the like.

As described above, although the present disclosure has been described with reference to the example embodiments, the present disclosure is not limited to the above. Various changes that can be understood by a person skilled in the art within the scope of the invention can be made to the configuration and details of the present disclosure. For example, in the second to fourth example embodiments, it is assumed that the acquisition units 111 and 121 acquires vehicle data from the vehicle apparatus 200 via a network. Alternatively, however, the acquisition units 111 and 121 may acquire the vehicle data from an external storage apparatus (not illustrated) that stores the vehicle data. The external storage apparatus may be a recording medium such as an SD card or a USB storage.

Some or all of the above-described example embodiments may be described as the following supplementary notes, but are not limited thereto.

(Supplementary note 1)

A simulated road generation system including:

an acquisition means for acquiring an image indicating a surrounding of a vehicle, and position information of the vehicle;
a detection means for detecting a demarcation line of a road from the image;
an estimation means for estimating, based on the position information of the vehicle and the demarcation line in the image, a road parameter including at least one of a number of lanes included in a predetermined region on a real space, a length of a lane, a width of a lane, and a curve curvature; and
a generation means for generating a simulated road, based on the road parameter.

(Supplementary note 2)

The simulated road generation system according to supplementary note 1, wherein

the estimation means
determines a divided image region, in the image, corresponding to a divided region and to be defined based on the demarcation line, for each of the divided regions formed in a case where a lane is divided into a predetermined length on a real space,
estimates a divided road parameter, based on the divided image region, and
generates a road parameter, based on the divided road parameter and the position information of the vehicle at a time of capturing the image.

(Supplementary note 3)

The simulated road generation system according to supplementary note 2, wherein the estimation means determines the predetermined length, based on a speed of the vehicle.

(Supplementary note 4)

The simulated road generation system according to supplementary note 2 or 3, wherein

the image is an image acquired by superimposing a guide line whose length and position are known on a real space on a captured image being captured by a camera of the vehicle, and
the estimation means determines the divided image region in the image, based on the guide line in the image.

(Supplementary note 5)

The simulated road generation system according to supplementary note 2 or 3, wherein the estimation means determines the divided image region in the image, based on a size and a position of an image region of another vehicle included in the image.

(Supplementary note 6)

The simulated road generation system according to supplementary note 1, wherein

the acquisition means acquires a first frame, a second frame being captured later than the first frame, and position information of the vehicle at a time of capturing each of the first and second frames,
the detection means detects a demarcation line of a road for each of the first and second frames, and

the estimation means estimates, when there is a shielded region in which a demarcation line is not detected in the first frame, a first road parameter of a region included in the first frame, based on the demarcation line of the second frame capturing the shielded region, and the position information of the vehicle at a time of capturing each of the first and second frames.

(Supplementary note 7)

The simulated road generation system according to supplementary note 6, wherein

the estimation means
estimates a first road parameter of a region included in the first frame, based on the position information of the vehicle at a time of capturing and the demarcation line of the first frame,
estimates a second road parameter of the shielded region, based on the position information of the vehicle at a time of capturing and the demarcation line of the second frame,
corrects the first road parameter, based on the second road parameter, and
the generation means generates a simulated road, based on the first road parameter after correction.

(Supplementary note 8)

The simulated road generation system according to supplementary note 6 or 7, wherein the generation means generates, as the simulated road, an image acquired by superimposing a simulated lane generated based on the first road parameter on the first frame.

(Supplementary note 9)

The simulated road generation system according to supplementary note 8, further including decision means for deciding whether a dangerous event related to another vehicle exists, based on the simulated lane and an image region of the another vehicle included in the simulated road.

(Supplementary note 10)

A simulated road generation method including:

an acquisition step of acquiring an image indicating a surrounding of a vehicle, and position information of the vehicle;
a detection step of detecting a demarcation line of a road from the image;
an estimation step of estimating, based on the position information of the vehicle and the demarcation line in the image, a road parameter including at least one of a number of lanes included in a predetermined region on a real space, a length of a lane, a width of a lane, and a curve curvature; and
a generation step of generating a simulated road, based on the road parameter.

(Supplementary note 11)

A non-transitory computer-readable medium storing a program for causing a computer to execute:

acquisition processing of acquiring an image indicating a surrounding of a vehicle, and position information of the vehicle;
detection processing of detecting a demarcation line of a road from the image;
estimation processing of estimating, based on the position information of the vehicle and the demarcation line in the image, a road parameter including at least one of a number of lanes included in a predetermined region on a real space, a length of a lane, a width of a lane, and a curve curvature; and
generation processing of generating a simulated road, based on the road parameter.

**Reference Signs List**

| 1, 2, 2a | SYSTEM |
| 10, 110, 120, 120a | SIMULATED ROAD GENERATION SYSTEM (SIMULATED ROAD GENERATION APPA- |

|  | RATUS) |
| 11, 111, 121 | ACQUISITION UNIT |
| 12, 112, 122 | DETECTION UNIT |
| 13, 113, 123 | ESTIMATION UNIT |
| 14, 114, 124 | GENERATION UNIT |
| 115, 125 | STORAGE UNIT |
| 116, 126 | DISPLAY UNIT |
| 127 | DECISION UNIT |
| 128 | OUTPUT UNIT |
| 200 | VEHICLE APPARATUS |
| 201 | COMMUNICATION UNIT |
| 202 | CAMERA |
| 203 | IMAGE GENERATION UNIT |
| 204 | VEHICLE INFORMATION ACQUISITION UNIT |
| 300 | GUIDE LINE |
| 400, 401, 402, 403 | OTHER VEHICLE |
| 500, 520 | DIVIDED REGION |
| 501, 521 | DIVIDED IMAGE REGION |
| 600, 620, 690 | SURROUNDING IMAGE |
| 600a, 600b, 620a, 620b | IMAGE |
| 700, 700a, 700b | IMAGE |
| 1000 | COMPUTER |
| 1010 | PROCESSOR |
| 1020 | STORAGE UNIT |
| 1030 | ROM |
| 1040 | RAM |
| 1050 | COMMUNICATION INTERFACE |
| 1060 | USER INTERFACE |
| A | LANE INCREASE AREA |
| L | DEMARCATION LINE |

**Claims**

1. A simulated road generation system comprising:

   acquisition means for acquiring an image indicating a surrounding of a vehicle, and position information of the vehicle;
   detection means for detecting a demarcation line of a road from the image;
   estimation means for estimating, based on the position information of the vehicle and the demarcation line in the image, a road parameter including at least one of a number of lanes included in a predetermined region on a real space, a length of a lane, a width of a lane, and a curve curvature; and
   generation means for generating a simulated road, based on the road parameter.

2. The simulated road generation system according to claim 1, wherein
   the estimation means

   determines a divided image region, in the image, corresponding to a divided region and to be defined based on the demarcation line, for each of the divided regions formed in a case where a lane is divided into a predetermined length on a real space,
   estimates a divided road parameter, based on the divided image region, and
   generates a road parameter, based on the divided road parameter and the position information of the vehicle at a time of capturing the image.

3. The simulated road generation system according to claim 2, wherein the estimation means determines the predetermined length, based on a speed of the vehicle.

4. The simulated road generation system according to claim 2 or 3, wherein

the image is an image acquired by superimposing a guide line whose length and position are known on a real space on a captured image being captured by a camera of the vehicle, and
the estimation means determines the divided image region in the image, based on the guide line in the image.

5. The simulated road generation system according to claim 2 or 3, wherein the estimation means determines the divided image region in the image, based on a size and a position of an image region of another vehicle included in the image.

6. The simulated road generation system according to claim 1, wherein

the acquisition means acquires a first frame, a second frame being captured later than the first frame, and position information of the vehicle at a time of capturing each of the first and second frames,
the detection means detects a demarcation line of a road for each of the first and second frames, and
the estimation means estimates, when there is a shielded region in which a demarcation line is not detected in the first frame, a first road parameter of a region included in the first frame, based on the demarcation line of the second frame capturing the shielded region, and the position information of the vehicle at a time of capturing each of the first and second frames.

7. The simulated road generation system according to claim 6, wherein
the estimation means

estimates a first road parameter of a region included in the first frame, based on the position information of the vehicle at a time of capturing and the demarcation line of the first frame,
estimates a second road parameter of the shielded region, based on the position information of the vehicle at a time of capturing and the demarcation line of the second frame,
corrects the first road parameter, based on the second road parameter, and the generation means generates a simulated road, based on the first road parameter after correction.

8. The simulated road generation system according to claim 6 or 7, wherein the generation means generates, as the simulated road, an image acquired by superimposing a simulated lane generated based on the first road parameter on the first frame.

9. A simulated road generation method comprising:

an acquisition step of acquiring an image indicating a surrounding of a vehicle, and position information of the vehicle;
a detection step of detecting a demarcation line of a road from the image;
an estimation step of estimating, based on the position information of the vehicle and the demarcation line in the image, a road parameter including at least one of a number of lanes included in a predetermined region on a real space, a length of a lane, a width of a lane, and a curve curvature; and
a generation step of generating a simulated road, based on the road parameter.

10. A non-transitory computer-readable medium storing a program for causing a computer to execute:

acquisition processing of acquiring an image indicating a surrounding of a vehicle, and position information of the vehicle;
detection processing of detecting a demarcation line of a road from the image;
estimation processing of estimating, based on the position information of the vehicle and the demarcation line in the image, a road parameter including at least one of a number of lanes included in a predetermined region on a real space, a length of a lane, a width of a lane, and a curve curvature; and
generation processing of generating a simulated road, based on the road parameter.

SIMULATED ROAD
GENERATION SYSTEM ⌒ 10

ACQUISITION UNIT ⌒ 11

DETECTION UNIT ⌒ 12

ESTIMATION UNIT ⌒ 13

GENERATION UNIT ⌒ 14

Fig. 1

START

↓

ACQUIRE SURROUNDING IMAGE AND
POSITION INFORMATION OF VEHICLE — S10

↓

DETECT DEMARCATION LINE
FROM SURROUNDING IMAGE — S11

↓

ESTIMATE ROAD PARAMETER FROM
POSITION INFORMATION OF VEHICLE
AND DEMARCATION LINE — S12

↓

GENERATE SIMULATED ROAD — S13

↓

END

Fig. 2

1

SIMULATED ROAD GENERATION APPARATUS — 110

STORAGE UNIT — 115

ACQUISITION UNIT — 111

DETECTION UNIT — 112

ESTIMATION UNIT — 113

DISPLAY UNIT — 116

GENERATION UNIT — 114

VEHICLE APPARATUS — 200

COMMUNICATION UNIT — 201

CAMERA — 202

IMAGE GENERATION UNIT — 203

VEHICLE INFORMATION ACQUISITION UNIT — 204

Fig. 3

Fig. 4

700

r23=
v2・Δt

r12=
v1・Δt

500L    500C        500R

P4

P3

Y1

P2

P1

Fig. 5

Fig. 6

620

Fig. 7

700a

Fig. 8

620a

Y3'

300

521L

521C

521R

Fig. 9

START

REPETITION FOR EACH SURROUNDING IMAGE

ACQUIRE SURROUNDING IMAGE, POSITION INFORMATION OF VEHICLE, AND VEHICLE SPEED INFORMATION — S20

DETECT DEMARCATION LINE IN SURROUNDING IMAGE — S21

DETERMINE DIVIDED LENGTH OF DIVIDED REGION — S22

DETERMINE DIVIDED IMAGE REGION THAT IS ASSOCIATED TO DIVIDED LENGTH ON REAL SPACE AND IS DEFINED BASED ON DEMARCATION LINE — S23

PERFORM PROJECTIVE TRANSFORMATION ON DIVIDED IMAGE REGION — S24

GENERATE DIVIDED ROAD PARAMETER — S25

END OF REPETITION

GENERATE ROAD PARAMETER — S26

GENERATE SIMULATED ROAD — S27

END

Fig. 10

Fig. 11

EP 4 290 491 A1

Fig. 12

29

Fig. 13

620b

SA'

Fig. 14

Fig. 15

START

ACQUIRE SURROUNDING IMAGE (FIRST FRAME) AT t=t0, POSITION INFORMATION OF VEHICLE, AND VEHICLE SPEED INFORMATION — S30

DETECT DEMARCATION LINE IN FIRST FRAME — S31

ESTIMATE FIRST ROAD PARAMETER FROM DEMARCATION LINE — S32

THERE IS SHIELDED REGION IN WHICH DEMARCATION LINE IS NOT DETECTED? — S33

No

Yes — S34

ESTIMATE CAPTURING TIME t1 (>t0) OF SHIELDED REGION

ACQUIRE SURROUNDING IMAGE (SECOND FRAME) AT t=t1 AND POSITION INFORMATION OF VEHICLE — S35

DETECT DEMARCATION LINE IN SECOND FRAME — S36

ESTIMATE SECOND ROAD PARAMETER FROM DEMARCATION LINE IN SHIELDED REGION — S37

CORRECT FIRST ROAD PARAMETER — S38

GENERATE SIMULATED LANE IN FIELD OF VIEW OF FIRST FRAME — S39

GENERATE SUPERIMPOSED IMAGE BY SUPERIMPOSING SIMULATED LANE ON FIRST FRAME — S40

END

Fig. 16

120a                                                              200                    2a

| SIMULATED ROAD GENERATION APPARATUS | VEHICLE APPARATUS |
|---|---|

125
STORAGE UNIT

121
ACQUISITION UNIT

201
COMMUNICATION UNIT

127
DECISION UNIT

122
DETECTION UNIT

202
CAMERA

128
OUTPUT UNIT

123
ESTIMATION UNIT

203
IMAGE GENERATION UNIT

126
DISPLAY UNIT

124
GENERATION UNIT

Fig. 17

START

DETERMINE IMAGE REGION OF ANOTHER
VEHICLE IN SUPERIMPOSED IMAGE — S50

DECIDE DANGEROUS EVENT RELATED
TO ANOTHER VEHICLE — S51

OUTPUT DECISION RESULT — S52

END

Fig. 18

Fig. 19

EP 4 290 491 A1

# INTERNATIONAL SEARCH REPORT

| International application No. |
|---|
| PCT/JP2021/009583 |

### A. CLASSIFICATION OF SUBJECT MATTER
Int.Cl. G08G1/00(2006.01)i
FI: G08G1/00J

According to International Patent Classification (IPC) or to both national classification and IPC

### B. FIELDS SEARCHED

Minimum documentation searched (classification system followed by classification symbols)
Int.Cl. G08G1/00

Documentation searched other than minimum documentation to the extent that such documents are included in the fields searched
| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2007-334450 A (TOYOTA MOTOR CO., LTD.) 27 December 2007 (2007-12-27), paragraphs [0020], [0022], [0023], [0025], [0029]-[0031], fig. 1 | 1, 9-10 |
| A | entire text, all drawings | 2-8 |
| Y | JP 2011-033572 A (NISSAN MOTOR CO., LTD.) 17 February 2011 (2011-02-17), paragraph [0020], fig. 1 | 1, 9-10 |

☐ Further documents are listed in the continuation of Box C. ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 May 2021 | 18 May 2021 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

| INTERNATIONAL SEARCH REPORT | International application No. |
|---|---|
| Information on patent family members | PCT/JP2021/009583 |

```
JP 2007-334450 A   27 December 2007    (Family: none)

JP 2011-033572 A   17 February 2011    (Family: none)
```

Form PCT/ISA/210 (patent family annex) (January 2015)

**EP 4 290 491 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019164611 A

- WO 2019107367 A